# EUROPEAN PATENT APPLICATION

(11) **EP 1 968 201 A1**
(43) Date of publication of application: **10.09.2008**
(21) Application number: 07290309.9
(22) Date of filing: 09.03.2007
(51) Int. Cl.: H04B 1/04

(54) **Predistortion with asymmetric usage of available bandwidth**

(71) Applicant: Alcatel Lucent, 75008 Paris (FR)
(72) Inventor: Walter, Ralf, 76199 Karlsruhe (DE); Ziegler, Rainer, 70563 Stuttgart (DE)
(74) Representative: Richardt, Markus Albert

(57) **Abstract**

The invention relates to a method for performing predistortion of a radio frequency signal, said radio frequency signal comprising a wanted signal and a first and a second intermodulation distortion signal sideband, comprising:
- defining a predistortion window,
- positioning said predistortion window asymmetrically around said radio frequency signal,
- predistorting said radio frequency signal within the positioned predistortion window.

## Description

### Technical field

The invention relates to a method for performing predistortion of a radio frequency signal, a power amplifier for amplifying a wanted signal comprising means for predistortion of a radio frequency signal, a mobile telecommunications system comprising an amplifier comprising means for predistortion with asymmetric usage, a mobile phone comprising a power amplifier comprising means for predistortion with asymmetric usage of available bandwidth and a computer program product comprising executable instructions for performing predistortion with asymmetric usage of available bandwidth.

### Background and related art

Active linearization has become an important technology in modern communication systems. In new generation mobile communication systems where spectrum efficient linear modulation formats are used, power amplifier linearity is a key requirement. Typically, power amplifiers are operated near to saturation where they are highly efficient but extremely non-linear.

Therefore, the disadvantage of operating a power amplifier near to saturation is that due to the amplifier non-linearity a resultant amplified signal comprises besides the amplified wanted signal intermodulation distortion signals located at frequencies above and at frequencies below the desired wanted output signal. Intermodulation distortion is highly undesirable, because it causes interference, cross talk and other effects which need to be suppressed in order to comply with requirements regarding transmitted signals in for example mobile communication systems.

Generally, intermodulation distortion can be reduced by different power amplifier linearization methods which can be classified mainly as feedback, feed forward and predistortion. Even though, predistortion is known to be a complicated linearization method applicable in telecommunication base stations, where extremely high linearity is required, it has been shown that with a careful design it is also applicable in handsets resulting in significant linearity improvement.

The concept of the predistortion technique is to insert a non-linear module between the input signal and the power amplifier. The non-linear module generates intermodulation distortion products, that are in anti phase with the intermodular distortion products produced by the power amplifier, reducing out of band emissions. This means, that the input signal is expanded prior to a power amplifier in such a way, that the non-linearities generated by the power amplifier are compensated. The predistortion circuit inversely models the amplifier's gain and phase characteristics and, when combined with the amplifier, produces an overall system that is more linear. Therewith, out of band emissions generated by the amplifier can be drastically reduced.

There are known methods for performing predistortion to improve the linearity of radio transmitter power amplifiers. For example US 5,877,653 discloses a linear power amplifier and method for removing the intermodulation distortion with a predistortion system and a feed forward system. US 6,757,338 discloses a predistortion linearizer for predistorting a radio frequency signal.

However, such predistortion techniques typically apply predistortion to a rather large signal bandwidth comprising both, the wanted signal and the intermodulation signals at frequencies below and above the desired output signal. This has the disadvantage, that high bandwidth predistortion circuits are required, which is rather cost intensive. Also, operation of such high-bandwidth circuits is rather power consuming. Another disadvantage is, that due to the still limited bandwidth of such highly sophisticated predistortion circuits it is rather impossible to predistort an amplified signal regarding its whole broad frequency bandwidth.

### Summary of the invention

The present invention provides a method for performing predistortion of a radio frequency signal, said radio frequency signal comprising a wanted signal and a first and a second intermodulation distortion signal sideband, comprising the steps of defining a predistortion window, positioning said predistortion window asymmetrically around said radio frequency signal and predistorting said radio frequency signal within the positioned predistortion window. Thereby, the predistortion window is preferably positioned including the wanted signal and a first intermodulation distortion signal.

The method for performing predistortion of a radio frequency signal according to the invention allows to use predistortion circuits with a considerably smaller bandwidth, since predistortion is not applied anymore to the full bandwidth of the amplified signal. In contrary, predistortion is exclusively performed on one side above or below the centre frequency of the wanted signal, which allows to even suppress spectral intermodulation components of third, fifth and higher order. Further, a limited predistortion bandwidth leads, due to lower technical demands on respective components, to considerable cost savings.

In an embodiment of the invention, the method for performing predistortion of a radio frequency signal further comprises determining predistortion parameters to be applied to the second intermodulation distortion signal, whereby said determination is based on analysis of the first intermodulation distortion signal. This has the advantage, that upon knowledge of only the first intermodulation distortion signal, a respective second intermodulation distortion signal can be theoretically calculated and predistortion can be applied to both, the first and to second intermodulation distortion signals.

Correlation of the spectral components of one side of the wanted signal can be described mathematically due to known physical effects. Thereby, by focusing on one side of the disturbing spectrum only, physical information for predistortion of both sides of disturbing spectrum can be obtained. Therefore, a limited detection bandwidth can be used to achieve a better spectral predistortion achievement for a high bandwidth on both frequency sides of the desired output signal.

In accordance with an embodiment of the invention, the position of the predistortion window is determined based on spectral output signal requirements of the intermodulation distortion signal sidebands. Since the spectral output signal requirements can be different for frequencies above and below the desired output signal, this allows to perform highly effective predistortion on the side of the spectrum with the higher spectral output signal requirements, whereas for the opposite side with lower spectral output signal requirements mathematical methods can be applied to predistort intermodulation signals on said side.

In another aspect, the invention relates to a power amplifier for amplifying a wanted signal, the power amplifier comprising input means for receiving the wanted signal, output means for providing an amplified output signal, the output signal comprising an amplified wanted signal and a first and a second intermodulation distortion signal, means for defining a predistortion window, means for positioning said predistortion window asymmetrically around the amplified wanted signal and means for predistorting the amplified wanted signal within the positioned predistortion window.

In accordance with an embodiment of the invention, the power amplifier further comprises means for determining predistortion parameters to be applied to the second intermodulation distortion signal, whereby the determination is based on analysis of the first intermodulation distortion signal.

In another aspect the invention relates to a mobile telecommunication system comprising a power amplifier according to the invention.

In another aspect the invention relates to a mobile telecommunications base station comprising power amplifier according to the invention.

In accordance with an embodiment of the invention, the base station is a GSM, UMTS, WiMAX or LTE base station.

In another aspect the invention relates to a mobile phone comprising a power amplifier according to the invention.

In another aspect the invention relates to a computer program product comprising executable instructions for performing the method for performing predistortion of a radio frequency signal.

### Brief description of the drawings

In the following preferred embodiments of the invention are described in greater detail by way of example only making reference to the drawings in which:
- Figure 1: is a block diagram of an embodiment of power amplifier comprising predistortion means,
- Figure 2a-2d: show a schematic illustrating the signal predistortion method according to the invention,
- Figure 3: shows a flowchart illustrating a method for performing the predistortion method according to the invention,
- Figure 4: shows a block diagram illustrating an embodiment of a predistortion unit and a power amplifier.

### Detailed description

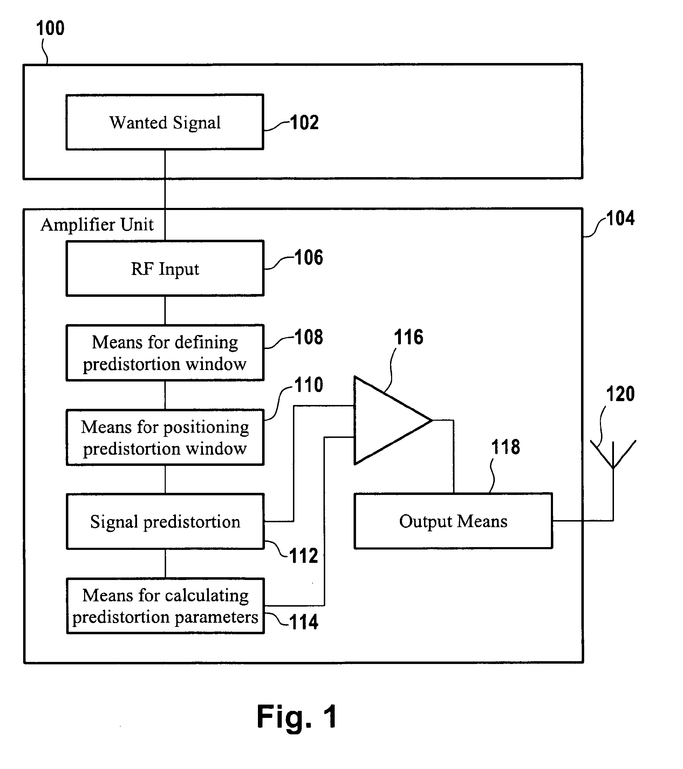

Fig. 1 is a block diagram of an embodiment of a power amplifier 104 comprising predistortion means according to the invention. A wanted signal 102, which is generated by for example a base station or a mobile phone 100 is inputted to the amplifier unit 104 with means of an interface 106. Using means for defining a predistortion window 108, the width of a predistortion window is set. The means 110 for positioning the predistortion window are used to position the predistortion window asymmetrically around said radio frequency signal. Thereby the predistortion window is preferably positioned including the wanted signal and a first intermodulation distortion signal which is output by the power amplifier 116.

Means 112 which are adapted for signal predistortion are used to predistort the signal within the asymmetrically positioned predistortion window. The predistorted signal is amplified by the power amplifier 116 and transmitted to an antenna 120 using an interface 118.

Typically, the amplified signal output by the power amplifier 116 also comprises a second intermodulation distortion signal, whereby the first and the second intermodulation distortion signals are located symmetrically at frequencies below and above the desired output signal. The spectral components of one side, either above or below the desired signal are correlated to the spectral components of the other side, for example due to physical effects which can be described using mathematical methods. Therefore, the means 114 are adapted for calculating predistortion parameters based on the intermodulation distortion signal on one frequency side of the desired output signal.

The calculated parameters are used to additionally predistort the signal to be inputted to the power amplifier 116. Therewith, any non-linearity the amplifier might possess is cancelled. This way, the power amplifier can be operated effectively near saturation where it is highly non-linear but extremely efficient.

Depending on the accuracy of mathematical modeling of the development of intermodulation distortion signals, even memory effects can be cancelled. Memory effects can for example develop due to modulation signals with different bandwidth which may generate a modulation signal dependent amplification behavior of the amplifier 116.

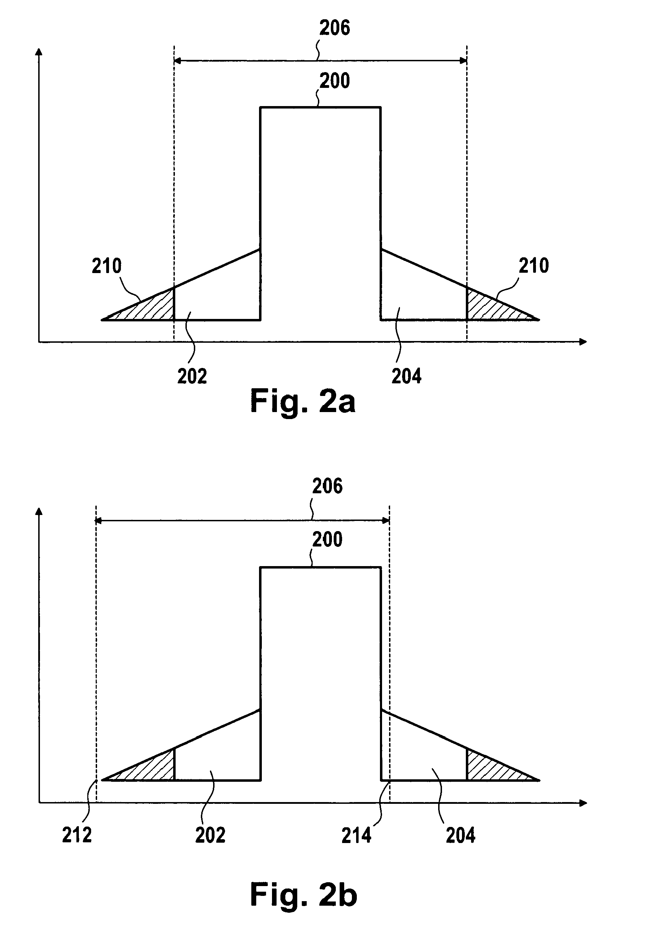

Figs. 2a to 2d show schematics illustrating the signal predistortion method according to the invention. Thereby, fig. 2a shows a state of the art predistortion technique. A wanted radio frequency signal 200, as well as a first intermodulation distortion signal 202 at a frequency below the wanted signal and a second intermodulation distortion signal 204 above the desired wanted signal 200 are generated by amplification of a radio frequency signal by means of a power amplifier. Predistortion is applied on the combined signal comprising the wanted signal 200 and the intermodulation distortion signals 202 and 204. Thereby, predistortion can only be incompletely performed within a spectrally limited window of a bandwidth 206.

In fig. 2b said predistortion window 206 is applied asymmetrically to the output signal of the power amplifier. Thereby, the predistortion window 206 is positioned including the wanted signal 200 and the complete first intermodulation distortion signal 202. Thereby, the low frequency side 212 of the predistortion window 206 also covers higher order (3^{rd}, 5^{th}, 7^{th}) intermodulation distortion signals. In contrary, the high frequency side 214 of the predistortion window 206 only covers a rather limited part of the second intermodulation distortion signal 204.

The reasons for preferably positioning the predistortion window 206 asymmetrically on the low frequency side of the wanted signal 200 could be for example special spectral output signal requirements of the intermodulation distortion signal sidebands, which have higher demands on the low frequency side of an output signal compared to the high frequency side of an output signal.

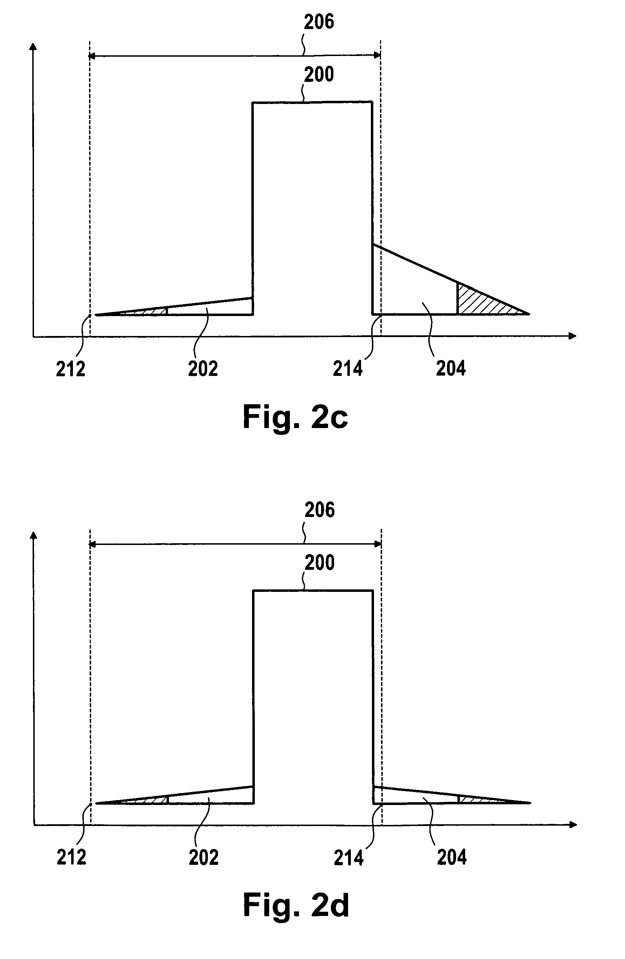

Fig. 2c shows the signal which has been predistorted within the predistortion window 206. The amplitude of the first intermodulation distortion signal 202 is drastically reduced. Such amplitude reduction can for example be performed by either negative feedback of the distorted signal or by separating distortion components of the amplifier output and feeding the distortion components forward to cancel the distortion in the amplified output signal. Also, predistortion can be realized in two different ways, namely analogue or digital implementation. Analogue predistortion can be realized by creating the required non-linearities cancelling effects of the power amplifier using analogue components. For digital predistortion, the system is realized with digital components. Analogue predistortion can be implemented at RF, IF or baseband, whereas typically digital predistortion is implemented at the baseband.

In order to additionally perform predistortion in order to compensate the second intermodulation distortion signal, predistortion parameters are determined based on analysis of the first intermodulation distortion signal. Therewith, by only analyzing the first intermodulation distortion signal 202, the second intermodulation distortion signal 204 can be predistorted by applying said parameters.

Fig. 2d shows the power amplifier output after combined predistortion of the first intermodulation distortion signal 202 and the second intermodulation distortion signal 204, whereby the predistortion parameters for the second intermodulation distortion signal 204 were calculated based on analysis of the first intermodulation distortion signal 202. Even though, the predistortion window 206 is positioned asymmetrically around the wanted signal 200 including mainly the first intermodulation distortion signal 202 and the wanted signal 200, a full suppression of said intermodulation distortion signals can be obtained.

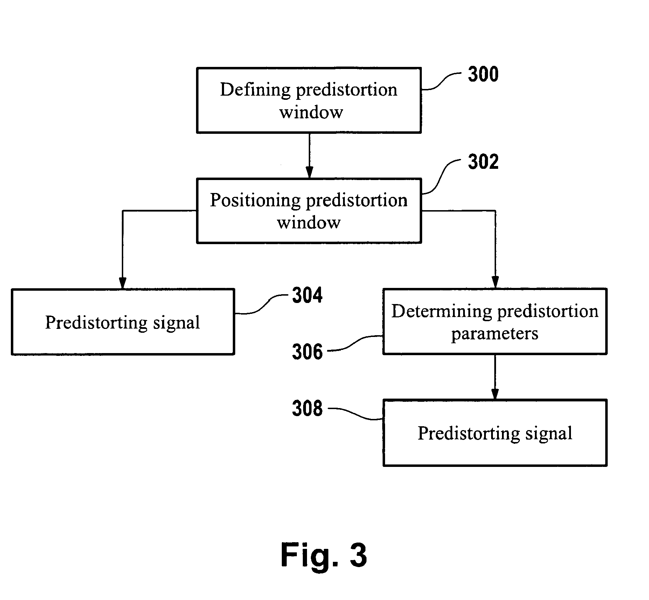

Fig. 3 shows a flowchart illustrating a method for performing the predistortion method according to the invention. In step 300, a predistortion window is defined. Definition of the predistortion window thereby comprises defining the width of said predistortion window. In step 302 the predistortion window is positioned asymmetrically around the wanted signal. Thereby the predistortion window is preferably positioned including the wanted signal and the first intermodulation distortion signal, whereby the position of the predistortion window is determined based on spectral output signal requirements of the intermodulation distortion signal sidebands.

In step 304, based on analysis of the signal comprised within the predistortion window, the signal is predistorted. However, since this only comprises predistortion of the first intermodulation distortion signal, additional predistortion parameters are calculated in step 306, whereby said parameters are indicative of the spectral characteristics of the second intermodulation distortion signal not covered by the predistortion window. Based on said calculated parameters, the signal is predistorted in step 308. Typically, steps 304 and 308 are performed in one combined predistortion step.

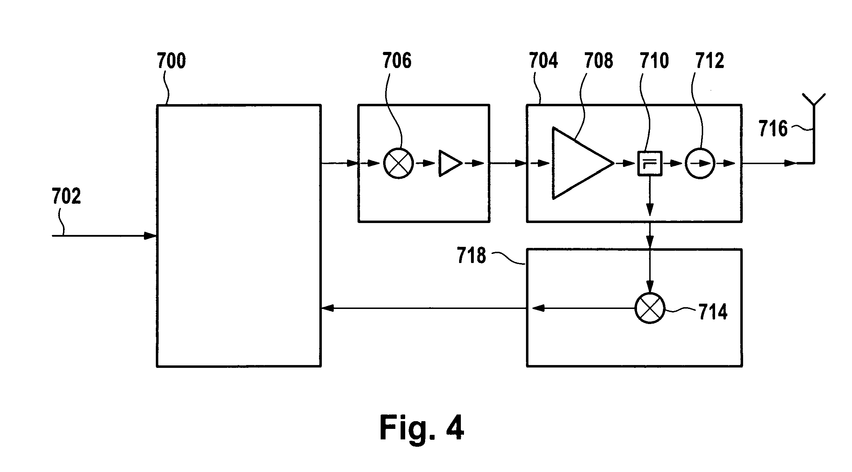

Fig. 4 shows a block diagram illustrating an embodiment of a predistortion unit 700 and an amplifier unit 704. The predistortion unit 700 predistorts the digital input signal 702 in order to compensate the non-linear properties of the amplifier unit 704. Thereby the input signal 702 comprises in phase and quadrature signals. Not shown here is a digital analogue converter used to transform digital signals into analogue signals. A frequency translator 706 is used to translate the input signals to their transmit radio frequency.

The radio frequency signal is then input into a power amplifier 708. The amplifier unit 704, which comprises the power amplifier 708, further comprises a coupler 710. The coupler 710 is used for coupling out a small portion of the transmit radio frequency signal for the purpose of analysis by the predistortion unit 700. The coupled out signal is fed into a mixer 714, which translates the transmit frequency into an intermediate frequency. The predistortion bandwidth is thereby located within the intermediate frequency bandwith.

Not shown here are means for signal filtering and amplification, which are applied to the signal translated to the intermediate frequency. The mixer 714, as well as the means for signal filtering and amplification of the signal at intermediate frequency are comprised within a feedback path 718. Before transmission of the signal from the feedback path 718 to the predistortion unit 700, the signal is sampled with an analogue digital converter and converted into digital in phase and quadrature signals. Thereby, the properties of the analogue digital converter are essential for the choice of the predistortion bandwidth.

The predistortion unit 700 comprises means for defining and positioning the predistortion window, as well as means for determining predistortion parameters to be applied to a second intermodulation distortion signal. Said determination is based on analysis of a first intermodulation distortion signal, whereby the radio frequency signal fed into the predistortion unit 700 with means of the feedback path 718 comprises both, a wanted signal and the first and second intermodulation distortion signals.

The amplifier unit 704 further comprises an isolator 712, which can also be adapted as a circulator. The isolator 712 is located at the output of the amplifier 708. The purpose of the isolator 712 is the maintenance of a constant impedance level which is essential for protection of final stage transistors (not shown here) from signals being reflected from for example defect cables to the antenna 716.

### List of Reference Numerals

- 100: signal generation unit
- 102: wanted signal
- 104: amplifier unit
- 106: RF-input
- 108: means for defining predistortion window
- 110: means for positioning predistortion window
- 112: signal predistortion
- 114: means for calculating predistortion parameters
- 116: power amplifier
- 118: RF-output
- 120: antenna

- 200: wanted RF signal
- 202: first intermodulation signal
- 204: second intermodulation signal
- 206: predistortion window width
- 210: intermodulation signal
- 212: position
- 214: position

- 700: predistortion block
- 702: input signal
- 704: power amplifier block
- 706: frequency translator
- 708: power amplifier
- 710: coupler
- 712: isolator
- 714: mixer
- 716: antenna
- 718: feedback path

## Claims

1. A method for performing predistortion of a radio frequency signal, said radio frequency signal comprising a wanted signal (200) and a first (202) and a second (204) intermodulation distortion signal sideband, comprising:
- positioning predefined predistortion window (206) asymmetrically around said radio frequency signal,
- predistorting said radio frequency signal within the positioned predistortion window (206).

2. The method for performing predistortion of a radio frequency signal of claim 1, wherein the predistortion window (206) is positioned including the wanted signal (200) and the first intermodulation distortion signal (202).

3. The method for performing predistortion of a radio frequency signal of claim 2, further comprising determining predistortion parameters to be applied to the second intermodulation distortion signal (204), said determination being based on analysis of the first intermodulation distortion signal (202).

4. The method for performing predistortion of a radio frequency signal of claim 1, wherein the position of the predistortion window (206) is determined based on spectral output signal requirements of the intermodulation distortion signal sidebands (202; 204).

5. A power amplifier (104) for amplifying a wanted signal (102), comprising:
- input means (106) for receiving the wanted signal (102),
- output means (118) for providing an amplified output signal, the output signal comprising an amplified wanted signal (200) and a first (202) and a second (204) intermodulation distortion signal,
- means (108) for defining a predistortion window (206),
- means (110) for positioning said predistortion window (206) asymmetrically around the amplified wanted signal (200),
- means (112) for predistorting the amplified wanted signal (200) within the positioned predistortion window (206).

6. The power amplifier (104) of claim 5, further comprising means (114) for determining predistortion parameters to be applied to the second intermodulation distortion signal (204), said determination being based on analysis of the first intermodulation distortion signal (202).

7. A mobile telecommunications system comprising a power amplifier (104) as claimed in claim 5.

8. A mobile telecommunications base station comprising a power amplifier (104) as claimed in claim 5.

9. The mobile telecommunications base station of claim 8, wherein the base station is a GSM, UMTS, WiMAX or LTE base station.

10. A mobile phone comprising a power amplifier (104) as claimed in claim 5.

11. A computer program product comprising executable instructions for performing a method as claimed in claims 1 to 4.

## Amended claims

### Amended claims in accordance with Rule 137(2) EPC.

**1.** A method for performing predistortion of a radio frequency signal, said radio frequency signal comprising a wanted signal (200) and a first (202) and a second (204) intermodulation distortion signal sideband, comprising:
- positioning predefined predistortion window (206) asymmetrically around said radio frequency signal, wherein the predistortion window (206) is positioned including the wanted signal (200) and the first intermodulation distortion signal (202),
- predistorting said radio frequency signal within the positioned predistortion window (206).

**2.** The method for performing predistortion of a radio frequency signal of claim 1, further comprising determining predistortion parameters to be applied to the second intermodulation distortion signal (204), said determination being based on analysis of the first intermodulation distortion signal (202).

**3.** The method for performing predistortion of a radio frequency signal of claim 1, wherein the position of the predistortion window (206) is determined based on spectral output signal requirements of the intermodulation distortion signal sidebands (202; 204).

**4.** A power amplifier (104) for amplifying a wanted signal (102), comprising:
- input means (106) for receiving the wanted signal (102),
- output means (118) for providing an amplified output signal, the output signal comprising an amplified wanted signal (200) and a first (202) and a second (204) intermodulation distortion signal,
- means (108) for defining a predistortion window (206),
- means (110) for positioning said predistortion window (206) asymmetrically around the amplified wanted signal (200), wherein the predistortion window (206) is positioned including the wanted signal (200) and the first intermodulation distortion signal (202),
- means (112) for predistorting the amplified wanted signal (200) within the positioned predistortion window (206).

**5.** The power amplifier (104) of claim 4, further comprising means (114) for determining predistortion parameters to be applied to the second intermodulation distortion signal (204), said determination being based on analysis of the first intermodulation distortion signal (202).

**6.** A mobile telecommunications system comprising a power amplifier (104) as claimed in claim 4.

**7.** A mobile telecommunications base station comprising a power amplifier (104) as claimed in claim 4.

**8.** The mobile telecommunications base station of claim 7, wherein the base station is a GSM, UMTS, WiMAX or LTE base station.

**9.** A mobile phone comprising a power amplifier (104) as claimed in claim 4.

**10.** A computer program product comprising executable instructions for performing a method as claimed in claims 1 to 3.
